**Europäisches Patentamt**

**European Patent Office**

**Office européen des brevets**

(19)

(11) Veröffentlichungsnummer: **0 095 058**

**B1**

(12) # EUROPÄISCHE PATENTSCHRIFT

(45) Veröffentlichungstag der Patentschrift:
02.09.87

(51) Int. Cl.⁴: **G 03 F 1/04**

(21) Anmeldenummer: **83104278.3**

(22) Anmeldetag: **02.05.83**

(54) Einrichtung für die stand- und passgerechte Filmmontage von Druckkontrollstreifen.

(30) Priorität: **26.05.82 DE 3219744**

(43) Veröffentlichungstag der Anmeldung:
**30.11.83 Patentblatt 83/48**

(45) Bekanntmachung des Hinweises auf die Patenterteilung:
**02.09.87 Patentblatt 87/36**

(84) Benannte Vertragsstaaten:
**FR GB IT SE**

(56) Entgegenhaltungen:
**DE-B-1 195 167**
**US-A-4 060 643**
**US-A-4 299 165**
**US-A-4 310 248**

(73) Patentinhaber: **Heidelberger Druckmaschinen Aktiengesellschaft, Kurfürsten- Anlage 52- 60 Postfach 10 29 40, D-6900 Heidelberg 1 (DE)**

(72) Erfinder: **Löffler, Gerhard, Kiefernweg 3, D-6909 Walldorf (DE)**
Erfinder: **Arendt, Franz, Lessingstrasse 8, D-6909 Walldorf (DE)**

(74) Vertreter: **Stoltenberg, Baldo Heinz- Herbert, c/o Heidelberger Druckmaschinen AG Kurfürsten- Anlage 52- 60, D-6900 Heidelberg 1 (DE)**

EP 0 095 058 B1

## Beschreibung

Die Erfindung betrifft eine Einrichtung für die stand- und paßgerechte Filmmontage von Druckkontrollstreifen.

Zur Qualitätsüberwachung bei der Herstellung und Beurteilung von Drucksachen, insbesondere von Rasterdrucken im Offsetverfahren, werden häufig Druckkontrollstreifen mitgedruckt. Je nach den gewünschten Informationsschwerpunkten unterscheiden sie sich im Aufbau und der Zusammensetzung. Bezogen auf den Farbeindruck gestatten sie die Bewertung der an einem Mehrfarbendruck beteiligten Einzelfarben, was im Zusammendruck der Drucksache selbst kaum möglich ist.

Darüber hinaus erlauben Druckkontrollstreifen u.a. eine selektive Beurteilung der neben der Passerhaltigkeit eines Druckes für den Farbeindruck wichtigsten Größen einer Farbe, nämlich Farbschichtdicke, Rasterpunktgröße und Rasterpunktform durch indirekte Meßwerte wie die Farbdichte.

Die am Druckkontrollstreifen ermittelten Meßwerte werden den einzelnen Farbzonen, in die der Farbkasten unterteilt ist, zugeordnet.

Diese notwendige Zuordnung macht es erforderlich, daß bei farbdichteabhängig gesteuerten Druckmaschinensystemen die Druckkontrollstreifen eine genau definierte Lage auf dem Druckbogen einnehmen müssen. Als Referenz für die richtige Zuordnung bzw. für die genau definierte Lage des Druckkontrollstreifens dient vorzugsweise die Maschinenmitte.

Zum Auffinden derselben verwenden die bekannten Systeme Markierungen im Druckkontrollstreifen selbst. Zusätzliche Ziffern für Format und Farbe dienen als weiteres Hilfsmittel.

Mitunter muß nun aber aus Platzgründen der Meßstreifen so schmal wie irgend möglich sein. In diesen Fällen müssen die Filme unmittelbar an der oberen und unteren Meßstreifenkante beschnitten werden, wobei natürlich neben anderen Informationen auch die Standmarkierungen entfallen. Eine Montage ist dann nur noch anhand eines Zweitmusters einer bereits fertigen Vergleichsmontage oder eines gedruckten Bogens möglich. Hinzu kommt, daß die für jede Druckfarbe existierenden Meßstreifenauszüge nacheinander auf die jeweiligen Montagen der Farbauszüge paßgenau aufgebracht werden müssen. Auch hierbei werden die Mittenmarkierungen oder Paßkreuze bzw. Paßlinien in Verbindung z. B. mit einem Maschinenstandbogen verwendet. Bei systemfreien Druckkontrollstreifen, die keine Maschinenmitten enthalten können, müssen bestimmte Paßlinien in Relation z. B. zum Maschinenstandbogen gebracht werden. Falsch angeordnete Montage einzelner Farben ist hierbei leicht möglich.

Noch problematischer wird es, wenn ein Druckkontrollstreifensatz zum Zwecke des Schön- und Widerdruckes zum Teil auf die Montagen der Schöndruckseite und zum Teil auf die der Widerdruckseite auf gebracht werden muß.

Da Druckkontrollstreifen in der Regel aus Einheiten bestehen, welche in der Filmmontage aneinandergereiht werden müssen, wiederholen sich die geschilderten Schwierigkeiten für jeden einzelnen Teilabschnitt, wobei hinzukommt, daß versehentlich oder in einer vorangegangenen Verwendung bewußt gekürzte Einheiten nur schwierig erkannt und deshalb nicht standgerecht montiert werden können.

In Anbetracht der aufgezeigten Schwierigkeiten bei der Anordnung des Druckkontrollstreifens liegt der Erfindung die Aufgabe zugrunde, eine Einrichtung zu schaffen, mit deren Hilfe die einzelnen Druckkontrollstreifeneinheiten stets stand- und paßgenau auf die Montagen der jeweiligen Einzelfarben montiert werden können.

Diese Aufgabe wird erfindungsgemäß durch eine Einrichtung gelöst, welche sich durch die Merkmale des Anspruches 1 kennzeichnet.

Dadurch kann in vorteilhafter Weise darauf verzichtet werden, auf oder an den jeweiligen Druckkontrollstreifen Informationen in Form von Markierungen oder sonstigen Kennzeichnungen aufzubringen, die gegebenenf alls beim Beschneiden der Filme verlorengehen könnten. Darüber hinaus sind Fehler beim Aneinanderreihen von Druckkontrollstreifeneinheiten ausgeschlossen.

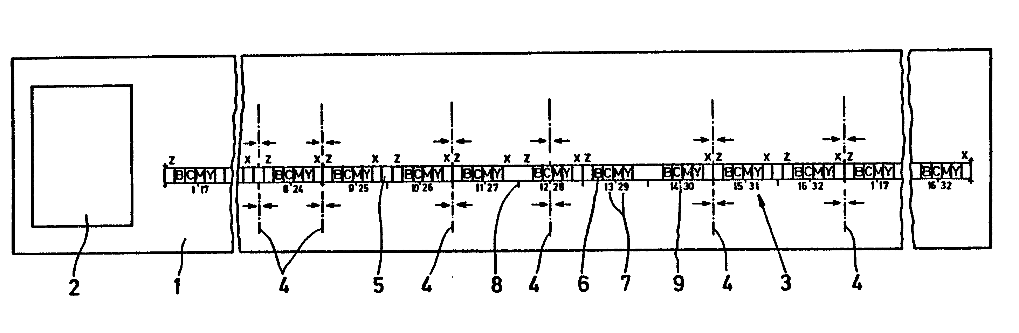

Ein Ausführungsbeispiel der Erfindung ist in der Zeichnung schematisch dargestellt.

Die Montagehilfe-Folie 1 besteht vorzugsweise aus einern dünnen, ebenen und verzugsarmen Material, wobei sich die Verzugsarmut insbesondere auf die Luftfeuchtigkeit bezieht. Die Durchsichtigkeit ist dabei für die Anfertigung seitenverkehrter Montagen von Bedeutung. Auf der dargestellten Montagehilfe-Folie 1 ist neben einem, mit allgemeinen Daten versehenen Kennzeichnungsfeld 2 eine vollständige, maßhaltige Abbildung eines Druckkontrollstreifens 3 aufgebracht, welche die für eine standgerechte Montage erforderlichen Farb- und Meßfeldart-Informationen sowie die Kennzeichnung der in Frage kornmenden Maschinenmitten 4, gegebenenfalls mit Kennzeichnung der Maschinentypen enthält. Dabei sind die einzelnen Farben mit verschiedenen Buchstaben gekennzeichnet, wobei z. B. B, C, M und Y für die Druckfarben Black, Cyan, Magenta und Yellow stehen. Die derart gekennzeichneten Meßfelder 6 sind gleichzeitig die Information dafür, daß es sich hierbei um Volltonfelder handelt. Die mit den Buchstaben X und Z gekennzeichneten Leerfelder 5 sind für die Volltöne einer fünften (X) oder auch sechsten Farbe (Z) vorgesehen oder werden bei weniger als sechs Druckfarben durch andere Meßfeldarten vorhandener Farben belegt.

Parallel zu den Meßfeldern 6 ist auf der Folie eine Skala abgebildet, die der Farbzoneneinteilung des Farbkastens entspricht. Die Zonen der Skala sind entsprechend der Farbzonennumerierung in dem Farbwerk der Druckmaschine mit fortlaufenden Ziffern 7 gekennzeichnet. Die einzelnen Zonen selbst wie auch die Zonenmitten sind durch längere Markierungsstriche 8 für die Zonen und kürzere Markierungsstriche 9 für die Zonenmitten gekennzeichnet.

Die so ausgeführte Montagehilfe-Folie 1 wird bei der Druckkontrollstreifen-Montage als Schablone unter die Montagefolie gelegt, wobei die markierte Maschinenmitte 4 den seitlichen Stand festlegt. Dies wäre auch mittels Registerlochung möglich, wobei die unterschiedlichen Lochungen der verschiedenen Maschinen zu berücksichtigen wären.

An Stelle des im aufgezeigten Ausführungsbeispiel dargestellten genauen Abbildes des Druckkontrollstreifens 3 wäre auch denkbar, lediglich eine aus den Meßfeldbegrenzungs- und Zonenteilungslinien 8 sowie den Druckplattenmitten 4 bestehende skelettartige Abbildung mit gleichem Informationsgehalt zu verwenden. Weiterhin wäre denkbar, die einzelnen Farbinformationen nicht mittels Kennzeichnung derselben sondern über eine mehrfarbige Ausgestaltung der Abbildung zu vermitteln. Das Aufbringen des Abbildes auf die transparent oder opak ausgestaltete Montagehilfe-Folie kann dabei fotochemisch, durch Bedrucken oder andere Kopierverfahren, erfolgen.

## Teileliste

1 Folie
2 Kennzeichnungsfeld
3 Druckkontrollstreifen
4 Maschinenmitte - Druckplattenmitte
5 Leerfeld
6 Meßfeld
7 Zonenziffer
8 Markierungsstrich - Zone
9 Markierungsstrich - Zonenmitte

## Patentansprüche

1. Einrichtung für die stand- und paßgerechte Filmmontage von Druckkontrollstreifen,
dadurch gekennzeichnet,
daß eine Folie (1) vorgesehen ist, welche bei der Druckkontrollstreifenmontage als Schablone für die Montagefolie verwendet wird und die für eine stand- und paßgerechte Filmmontage erforderlichen Farb- und Meßfeldinformationen sowie die Kennzeichnung der Druckplattenmitten enthält.

2. Einrichtung nach Anspruch 1,
dadurch gekennzeichnet,
daß auf der Folie (1) ein genaues Abbild eines Druckkontrollstreifens (3) aufgebracht ist, bestehend aus den genauen Meßfeld-Positionen (6), der Markierung der Farbzonen (8) und/oder deren Mitten (9) und Bezeichnungen (7), der Farbkennzeichnung und der Kennzeichnung der Druckplattenmitten (4).

3. Einrichtung nach Anspruch 1,
dadurch gekennzeichnet,
daß auf der Folie (1) lediglich eine skelettartige Abbildung eines Druckkontrollstreifens aufgebracht ist, im wesentlichen bestehend aus den Meßfeldbegrenzungs- und Zonenteilungslinien (8) sowie den Druckplattenmitten (4).

4. Einrichtung nach Anspruch 2 oder 3,
dadurch gekennzeichnet,
daß die Abbildung einfarbig ausgeführt ist und die Farbinformation durch Kennzeichnung erfolgt.

5. Einrichtung nach Anspruch 2 oder 3,
dadurch gekennzeichnet,
daß die Abbildung mehrfarbig ausgeführt ist.

6. Einrichtung nach Anspruch 1,
dadurch gekennzeichnet,
daß die Folie (1) vorzugsweise aus dünnem, ebenen und verzugsarmem Material besteht.

7. Einrichtung nach Anspruch 1,
dadurch gekennzeichnet,
daß das Folienmaterial transparent ist.

8. Einrichtung nach Anspruch 1,
dadurch gekennzeichnet,
daß das Folienmaterial opak ist.

## Claims

1. Device for correctly positioned in-register film mounting of print control strips,
wherein there is provided a foil (1) which is used as a template for the mounting film when mounting the print control strip, said foil containing the ink and measuring field information as well as the identification marks of the printing plate centres necessary for correctly positioned in-register film mounting.

2. Device according to Claim 1,
wherein on the foil (1) there is applied an exact image of a print control strip (3) consisting of the exact measuring field positions (6), the marking of the ink zones (8) and/or their centres (9), the ink zone digits (7), the ink coding and the identification marks of the printing plate centres (4).

3. Device according to Claim 1,
wherein on said foil (1) there is merely applied a skeleton-type image of a print control strip consisting essentially of measuring field limiting lines and zone dividing lines (8) as well as of the identification marks of the printing plate centres (4).

4. Device according to Claim 2 or 3,
wherein said image is of a single colour and said ink information is given in a code.

5. Device according to Claim 2 or 3,

wherein said image is multicoloured.

6. Device according to Claim 1, wherein said foil (1) preferably consists of a thin, smooth material with low deformability.

7. Device according to Claim 1, wherein the material of said foil (1) is transparent.

8. Device according to Claim 1, wherein the material of said foil (1) is opaque.

## Revendications

1. Dispositif pour le positionnement et le repérage de bandes de contrôle d'impression sur un film de montage, caractérisé en ce qu'il est prévu une feuille (1) qui est utilisée, lors du montage de la bande de contrôle d'impression, comme gabarit pour la feuille de montage et qui contient des informations de zones de couleurs et de zones de mesure nécessaires pour un montage de film correct en ce qui concerne le positionnement et le repérage, ainsi que la définition du milieu de plaque d'impression.

2. Dispositif selon la revendication 1, caractérisé en ce qu'on met en place sur la feuille (1) une image exacte d'une bande de contrôle d'impression (3), se composant des positions exactes de zone de mesure (6), du repérage des zones de couleurs (8) et/ou de leurs milieux (9) et de leurs désignations (7), de la caractéristique de couleur et de la caractéristique de milieu de plaque d'impression (4).

3. Dispositif selon la revendication 1, caractérisé en ce qu'on met en place sur la feuille (1) simplement une image en forte de squelette d'une bande de contrôle d'impression, se composant dans l'essentiel des lignes de délimitation de plages de mesure et de division de zones (8) ainsi que des milieux de plaques d'impression (4).

4. Dispositif selon la revendication 2 ou 3, caractérisé en ce que l'image est réalisée en une seule couleur et l'information-couleur est établie au moyen de caractéristiques.

5. Dispositif selon la revendication 2 ou 3, caractérisé en ce que l'image est réalisée en plusieurs couleurs.

6. Dispositif selon la revendication 1, caractérisé en ce que la feuille (1) se compose avantageusement d'une matière mince, plane et peu déformable.

7. Dispositif selon la revendication 1 caractérisé en ce que la matière de feuille est transparente.

8. Dispositif selon la revendication 1, caractérisé en ce que la matière de feuille est opaque.

BCMY 1 17  BCMY 8 24  BCMY 9 25  BCMY 10 26  BCMY 11 27  BCMY 12 28  BCMY 13 29  BCMY 14 30  BCMY 15 31  BCMY 16 32  BCMY 1 17  BCMY 16 32

2  1  4  5  4  8  4  6  7  9  4  3  4

0 095 058